# DEMANDE DE BREVET EUROPEEN

(11) **EP 3 832 703 A1**
(43) Date de publication de la demande: **09.06.2021**
(21) Numéro de dépôt: 20209107.0
(22) Date de dépôt: 23.11.2020
(51) Int. Cl.: H01L 21/56, H01L 21/78, H01L 23/31

(54) **PROCEDE DE FABRICATION DE PUCES ELECTRONIQUES**

(30) Priorité: 04.12.2019 FR 1913744
(71) Demandeur: STMicroelectronics (Tours) SAS, 37100 Tours (FR)
(72) Inventeur: DE CRUZ, Michael, 37380 MONNAIE (FR); ORY, Olivier, 37100 TOURS (FR)
(74) Mandataire: Cabinet Beaumont

(57) **Abrégé**

**Procédé de fabrication de puces électroniques**

La présente description concerne un procédé de fabrication de puces électroniques comprenant les étapes suivantes :
a. former, du coté d'une première face d'un substrat semiconducteur (11), dans et sur lequel a été formée une pluralité de circuits intégrés (13), des métallisations reliant des contacts de circuits intégrés (13) voisins ; et
b. former, du coté de ladite première face du substrat (11), des premières tranchées (21) séparant latéralement les circuits intégrés (13) et couper les métallisations reliant des circuits intégrés (13) adjacents, pour former au moins une portion (19') de métallisations au niveau de chacun des circuits (13) adjacents.

## Description

### Domaine technique

La présente description concerne un procédé de fabrication de puces électroniques. Elle vise plus particulièrement un procédé de fabrication de puces dites à montage en surface (SMD - Surface Mounted Device), c'est-à-dire comportant, du côté d'au moins une face, une ou plusieurs métallisations de connexion destinées à être brasées à des plages de connexion correspondantes d'un dispositif extérieur, par exemple une carte de circuit imprimé ou une autre puce.

### Technique antérieure

Dans certaines applications, il existe un besoin pour des puces à montage en surface dans lesquelles les métallisations de connexion, destinées à être brasées à un dispositif extérieur, s'étendent jusqu'aux flancs des puces. On parle alors de puces à flancs mouillables. Lors du brasage, une partie du matériau de brasage remonte sur les flancs des puces, ce qui permet de mettre en oeuvre une inspection visuelle de la qualité des connexions. Ce besoin existe par exemple dans des domaines tels que le domaine automobile ou le domaine médical.

### Résumé de l'invention

Il serait souhaitable d'améliorer au moins en partie certains aspects des procédés connus de fabrication de puces électroniques à flancs mouillables.

Un mode de réalisation prévoit un procédé de fabrication de puces électroniques comprenant les étapes suivantes :
a. former, du coté d'une première face d'un substrat semiconducteur, dans et sur lequel a été formée une pluralité de circuits intégrés, des métallisations reliant des contacts de circuits intégrés voisins ; et
b. former, du coté de ladite première face du substrat, des premières tranchées séparant latéralement les circuits intégrés et couper les métallisations reliant des circuits intégrés adjacents, pour former au moins une portion de métallisations au niveau de chacun des circuits adjacents.

Selon un mode de réalisation, les métallisations sont en contact, uniquement, avec des contacts métalliques des circuits intégrés.

Selon un mode de réalisation, l'étape a) est suivie de l'étape b).

Selon un mode de réalisation, les premières tranchées s'étendent verticalement dans le substrat sur une profondeur supérieure à celle des circuits intégrés et inférieure à l'épaisseur du substrat.

Selon un mode de réalisation, l'étape b) est suivie d'une étape c) de dépôt d'une couche d'une première résine sur l'ensemble de la première face, ladite première résine pénétrant dans les premières tranchées et recouvrant lesdites portions desdites métallisations.

Selon un mode de réalisation, l'étape c) est suivi d'une étape d) de planarisation de la première face jusqu'à découvrir lesdites portions desdites métallisations.

Selon un mode de réalisation, l'étape d) est effectuée jusqu'à découvrir lesdites portions desdites métallisations sur une surface suffisante pour pouvoir souder la puce, par sa première face, sur un dispositif autre que la puce, la planarisation étant de préférence effectuée jusqu'à découvrir lesdites portions desdites métallisations sur une longueur supérieure à environ 20 µm.

Selon un mode de réalisation, l'étape a) est précédée d'une étape e) de formation de deuxièmes tranchées du coté de la première face, séparant latéralement les circuits intégrés, les deuxièmes tranchées s'étendant verticalement dans le substrat sur une profondeur supérieure à celle des circuits intégrés et inférieure à l'épaisseur du substrat.

Selon un mode de réalisation, l'étape a) est suivie d'une étape f) de dépôt d'une couche d'une première résine sur l'ensemble de la première face, ladite première résine pénétrant dans les deuxièmes tranchées et recouvrant lesdites métallisations.

Selon un mode de réalisation :
l'étape e) est précédée d'une étape g) de formation de bossages à l'aplomb des circuits intégrés ; et
entre les étape e) et a), est réalisée une étape h) de dépôt d'une première couche d'une première résine sur l'ensemble de la première face, ladite première résine pénétrant dans les deuxièmes tranchées et recouvrant les bossages, et de planarisation de ladite première couche au moins jusqu'à découvrir les bossages.

Selon un mode de réalisation, les métallisations sont reliées aux circuits intégrés par l'intermédiaire des bossages.

Selon un mode de réalisation, l'étape a) est suivie par une étape i) de dépôt d'une deuxième couche de la première résine sur la première couche de la première résine.

Selon un mode de réalisation, l'étape f) ou i) est suivie d'une étape j) de planarisation de la première face de façon à découvrir chaque métallisation, lesdites métallisations étant découvertes sur une longueur, par exemple, supérieure à environ 200 µm.

Selon un mode de réalisation, l'étape d) ou j) est suivie d'une étape k) d'amincissement du substrat par une deuxième face du substrat, située à l'opposé de la première face, au moins jusqu'à atteindre la première résine, et de dépôt d'une couche d'une deuxième résine sur la deuxième face.

Selon un mode de réalisation, l'étape k) est suivie par une étape 1) comprenant les étapes de :
retrait partiel de la couche de la première résine, sur une hauteur inférieure ou égale à la hauteur desdites portions desdites métallisations, pour former des ouvertures situées en vis-à-vis des premières tranchées et s'étendant sur une largeur supérieure ou égale à celle des premières tranchées, de façon à dégager un flanc d'au moins une portion de chaque circuit intégré ; et
singuler les puces par découpe selon un chemin de découpe dans les premières tranchées, sur une largeur inférieure à la largeur des premières tranchées.

Selon un mode de réalisation, l'étape k) est suivie de l'étape b).

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 illustre, par une vue en coupe, une étape d'un procédé de fabrication de puces électroniques selon un premier mode de réalisation ;
la figure 2 illustre, par des vues (A) et (B), respectivement en coupe et de dessus, une autre étape du procédé de fabrication de puces électroniques selon le premier mode de réalisation ;
la figure 3 illustre, par une vue de dessus, une variante de l'étape de la figure 2 ;
la figure 4 illustre, par des vues (A) et (B), respectivement en coupe et de dessus, une autre étape du procédé de fabrication de puces électroniques selon le premier mode de réalisation ;
la figure 5 illustre, par une vue de dessus, une variante de l'étape de la figure 4 ;
la figure 6 illustre, par une vue en coupe, une autre étape du procédé de fabrication de puces électroniques selon le premier mode de réalisation ;
la figure 7 illustre, par une vue en coupe, une autre étape du procédé de fabrication de puces électroniques selon le premier mode de réalisation ;
la figure 8 illustre, par une vue en coupe, une autre étape du procédé de fabrication de puces électroniques selon le premier mode de réalisation ;
la figure 9 illustre, par une vue en coupe, une autre étape du procédé de fabrication de puces électroniques selon le premier mode de réalisation ;
la figure 10 illustre, par une vue en coupe, une autre étape du procédé de fabrication de puces électroniques selon le premier mode de réalisation ;
la figure 11 illustre, par une vue en coupe, une étape d'un procédé de fabrication de puces électroniques selon un deuxième mode de réalisation ;
la figure 12 illustre, par une vue en coupe, une autre étape du procédé de fabrication de puces électroniques selon le deuxième mode de réalisation ;
la figure 13 illustre, par une vue en coupe, une autre étape du procédé de fabrication de puces électroniques selon le deuxième mode de réalisation ;
la figure 14 illustre, par une vue en coupe, une autre étape du procédé de fabrication de puces électroniques selon le deuxième mode de réalisation ;
la figure 15 illustre, par une vue en coupe, une autre étape du procédé de fabrication de puces électroniques selon le deuxième mode de réalisation ;
la figure 16 illustre, par une vue en coupe, une autre étape du procédé de fabrication de puces électroniques selon le deuxième mode de réalisation ;
la figure 17 illustre, par une vue en coupe, une autre étape du procédé de fabrication de puces électroniques selon le deuxième mode de réalisation ;
la figure 18 illustre, par une vue en coupe, une autre étape du procédé de fabrication de puces électroniques selon le deuxième mode de réalisation ;
la figure 19 illustre, par une vue en coupe, une étape d'un procédé de fabrication de puces électroniques selon un troisième mode de réalisation ;
la figure 20 illustre, par une vue en coupe, une autre étape du procédé de fabrication de puces électroniques selon le troisième mode de réalisation ;
la figure 21 illustre, par une vue en coupe, une autre étape du procédé de fabrication de puces électroniques selon le troisième mode de réalisation ;
la figure 22 illustre, par une vue en coupe, une autre étape du procédé de fabrication de puces électroniques selon le troisième mode de réalisation ;
la figure 23 illustre, par une vue en coupe, une autre étape du procédé de fabrication de puces électroniques selon le troisième mode de réalisation ;
la figure 24 illustre, par une vue en coupe, une autre étape du procédé de fabrication de puces électroniques selon le troisième mode de réalisation ;
la figure 25 illustre, par une vue en coupe, une autre étape du procédé de fabrication de puces électroniques selon le troisième mode de réalisation ;
la figure 26 illustre, par une vue en coupe, une autre étape du procédé de fabrication de puces électroniques selon le troisième mode de réalisation ;
la figure 27 illustre, par une vue en coupe, une autre étape du procédé de fabrication de puces électroniques selon le troisième mode de réalisation ;
la figure 28 illustre, par une vue en coupe, une autre étape du procédé de fabrication de puces électroniques selon le troisième mode de réalisation ;
la figure 29 illustre, par une vue en coupe, une étape d'un procédé de fabrication de puces électroniques selon un quatrième mode de réalisation ;
la figure 30 illustre, par une vue en coupe, une autre étape du procédé de fabrication de puces électroniques selon le quatrième mode de réalisation ;
la figure 31 illustre, par une vue en coupe, une autre étape du procédé de fabrication de puces électroniques selon le quatrième mode de réalisation ;
la figure 32 illustre, par une vue en coupe, une autre étape du procédé de fabrication de puces électroniques selon le quatrième mode de réalisation ;
la figure 33 illustre, par une vue en coupe, une autre étape du procédé de fabrication de puces électroniques selon le quatrième mode de réalisation ;
la figure 34 illustre, par une vue en coupe, une autre étape du procédé de fabrication de puces électroniques selon le quatrième mode de réalisation ;
la figure 35 illustre, par une vue en coupe, une autre étape du procédé de fabrication de puces électroniques selon le quatrième mode de réalisation ;
la figure 36 illustre, par une vue en coupe, une autre étape du procédé de fabrication de puces électroniques selon le quatrième mode de réalisation ; et
la figure 37 représente, par une vue en perspective, une variante de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, la réalisation des circuits intégrés, présents dans les puces électroniques décrites, n'a pas été détaillée.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

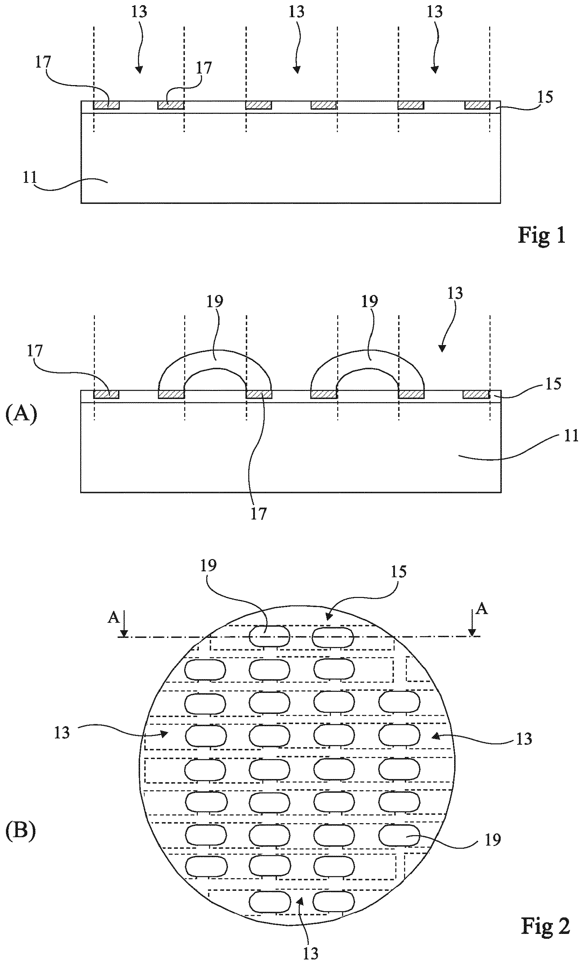

Les figures 1 à 10 illustrent, de façon schématique et partielle, des étapes successives d'un exemple d'un procédé de fabrication de puces électroniques selon un premier mode de réalisation.

La figure 1 illustre, par une vue en coupe, une étape du procédé de fabrication de puces électroniques selon ce premier mode de réalisation.

Plus particulièrement, la figure 1 est une vue, partielle et schématique, d'une structure de départ comprenant un substrat semiconducteur 11 dans et sur lequel des circuits intégrés 13 ont été préalablement formés. Les circuits 13 sont, par exemple, tous identiques aux dispersions de fabrication près. Le substrat 11 peut correspondre à une plaque d'un matériau semiconducteur, par exemple du silicium. Le substrat 11 a, par exemple une épaisseur comprise entre environ 50 µm et environ 900 µm, par exemple une épaisseur d'environ 200 µm.

Dans la suite de la description, on considère la face supérieure de la structure, dans l'orientation de la figure 1, comme étant la face avant et la face inférieure de la structure, dans l'orientation de la figure 1, comme étant la face arrière.

La structure de la figure 1 comprend en outre un empilement de couches isolantes et conductrices 15, appelé empilement d'interconnexion, revêtant la face supérieure du substrat 11. Des éléments d'interconnexion des composants de chaque circuit 13 sont formés dans cet empilement 15. L'empilement d'interconnexion 15 comprend, en particulier, pour chaque circuit intégré 13, un ou plusieurs plots de contact métalliques 17 affleurant au niveau de la face supérieure des circuits intégrés 13 et destinés à être connectés à un dispositif extérieur à la puce réalisée.

Chaque circuit intégré 13 comprend, par exemple, un ou plusieurs composants électroniques (transistors, diodes, thyristors, triacs, etc.).

En figure 1, trois circuits intégrés 13 ont été représentés, étant entendu que, en pratique, le nombre de circuits intégrés 13 formés dans et sur le substrat 11 peut être bien plus important.

La figure 2 illustre, par des vues (A) et (B), respectivement en coupe et de dessus, une autre étape du procédé de fabrication de puces électroniques selon le premier mode de réalisation.

Plus particulièrement, la figure 2 illustre par des vues, partielles et schématiques, une étape de formation de métallisations 19 de connexion sur et en contact avec les plots métalliques 17 de deux circuits 13 adjacents. La vue (A) correspond à une vue en coupe, selon le plan de coupe A-A de la vue (B).

Les métallisations 19 sont fabriquées par un dépôt métallique, sur et au contact des plots 17, au travers d'un masque (non représenté). Dans le mode de réalisation de la figure 2, les ouvertures du masque (non représenté) sont volontairement désalignées par rapport à la position des plots de contact 17 sous-jacents. Plus particulièrement, des ouvertures du masque (non représenté) sont volontairement positionnées entre deux plots de contact 17 de deux circuits 13 voisins de sorte que chaque ouverture soit positionnée en regard d'une partie de chacun des deux plots 17 desdits deux circuits 13 voisins.

Le métal, dirigé par une ouverture du masque (non représenté) entre deux plots 17 de deux circuits 13 adjacents, se dépose sur lesdits deux plots 17 de contact en les reliant pour former un pont. Les deux bases du pont sont chacune en contact avec un plot de contact 17 d'un desdits deux circuits 13 adjacents.

Ce phénomène lié au désalignement du masque est généralement indésirable car il court circuite deux plots 17 de contact. Dans le présent mode de réalisation, on tire profit de ce phénomène en le favorisant de façon à former un pont ou une partie d'anneau conducteur reliant deux contacts 17 de deux circuits 13 distincts.

Chaque métallisation 19 est donc allongée entre les deux plots 17 des deux circuits 13 adjacents qu'elle relie.

En pratique, l'ouverture du masque est circulaire, carrée ou allongée dans la direction reliant les deux contacts 17.

Les métallisations 19 peuvent être en un alliage à base d'étain, par exemple un alliage à base d'étain et d'argent (SnAg).

A titre d'exemple, les métallisations 19 sont toutes orientées dans la même direction (vue (B)).

En pratique, le substrat 11 peut comprendre une pluralité de circuits intégrés 13 identiques, tous destinés à devenir des puces à flancs mouillables, disposée sur l'ensemble de la structure. Les circuits situés sur le bord des plaquettes semiconductrices sont incomplets de part la forme habituelle circulaire des plaquettes. Ces circuits incomplets sont généralement perdus. Dans le mode de réalisation décrit, on utilise cependant leurs contacts en regard de contacts de circuits complets adjacents pour former des ponts avec ces derniers.

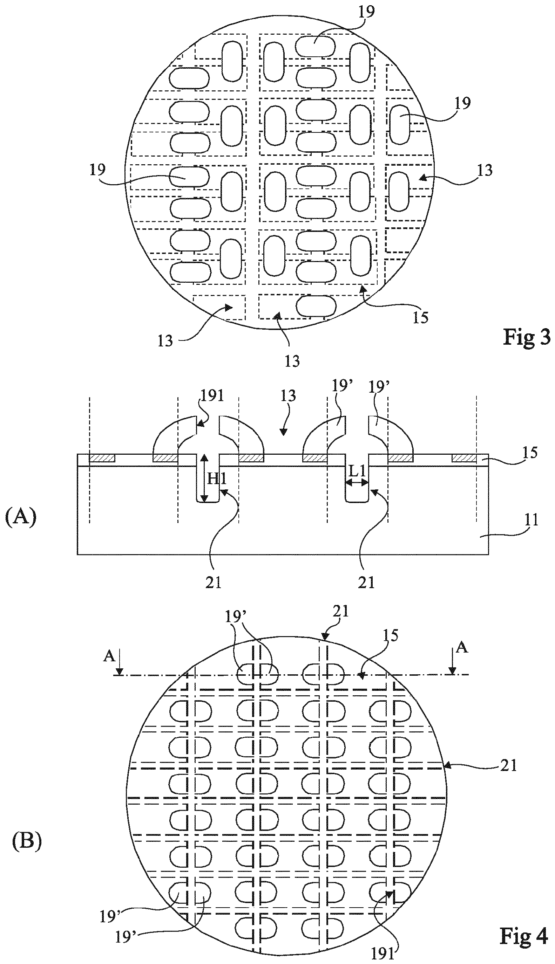

La figure 3 illustre, par une vue de dessus, une variante de l'étape de la figure 2.

La structure illustrée en figure 3 diffère de celle illustrée en figure 2 (vue (B)) par le fait que les métallisations 19 sont orientées dans deux directions orthogonales. Plus généralement, les métallisations 19 peuvent être réalisées en biais par rapport à l'alignement des circuits, voire relier des contacts 17 des coins de deux circuits 13 voisins.

La figure 4 illustre, par des vues (A) et (B), respectivement en coupe et de dessus, une autre étape du procédé de fabrication de puces électroniques selon le premier mode de réalisation.

Plus particulièrement, la figure 4 illustre par des vues, partielles et schématiques, une étape de formation de premières tranchées 21 en face supérieure de la structure obtenue à l'issue des étapes des figures 1 à 3. La vue (A) correspond à une vue en coupe, selon le plan de coupe A-A de la vue (B).

Les premières tranchées 21 s'étendent entre les circuits 13 de sorte que, en vue de dessus, chaque circuit 13 soit séparé de son voisin par une tranchée 21. A titre d'exemple, chaque circuit 13 est entièrement délimité, latéralement, par des tranchées 21. Les tranchées peuvent, par exemple, en vue de dessus, former une grille continue s'étendant entre les circuits intégrés 13.

Dans l'exemple représenté, les tranchées 21 s'étendent verticalement, depuis la face supérieure de l'empilement 15, et se prolongent dans le substrat 11, sur une profondeur supérieure à la profondeur des circuits intégrés 13. Les tranchées 21 s'étendant verticalement.

Les tranchées 21 sont par exemple, réalisées par sciage. Lors de l'étape de sciage, la structure peut être montée sur un film support, non représenté, disposé du coté de la face inférieure du substrat 11, le film étant ensuite ôté après la formation des tranchées 21.

L'opération de sciage coupe les métallisations 19 au droit des tranchées 21, de façon à séparer chaque métallisation 19 en deux portions 19' de métallisation 19. Cette séparation fait apparaitre des flancs 191 de part et d'autre des tranchées 21 sur les portions 19'.

En d'autres termes, les métallisations 19 sont coupées pour former au moins une portion 19' de métallisations 19 au niveau de chacun des circuits 13 adjacents.

Dans cet exemple, les tranchées 21 sont non traversantes, c'est-à-dire qu'elles ne débouchent pas du côté de la face inférieure du substrat 11. Les tranchées 21 s'étendent verticalement sur une profondeur H1, par exemple comprise entre environ 30 µm et environ 400 µm, de préférence comprise entre environ 100 µm et environ 200 µm. Les tranchées 21 ont par exemple une largeur L1 comprise entre environ 5 µm et environ 100 µm, de préférence comprise entre environ 30 µm et environ 40 µm, la largeur L1 étant préférentiellement égale à environ 35 µm, par exemple égale à 35 µm.

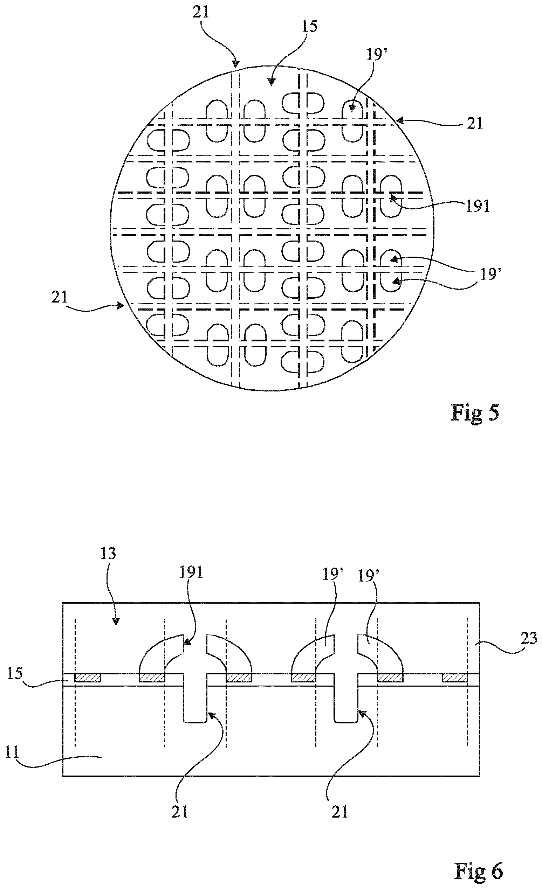

La figure 5 illustre, par une vue de dessus, une variante de l'étape de la figure 4.

La structure illustrée en figure 5 diffère de celle illustrée en figure 4 (vue (B)) par le fait que l'étape de formation des tranchées 21 est effectuée à partir de la structure illustrée en figure 3.

La figure 6 illustre, par une vue en coupe, une autre étape du procédé de fabrication de puces électroniques selon le premier mode de réalisation.

Plus particulièrement, la figure 6 illustre par une vue, partielle et schématique, une étape de dépôt d'une première couche 23 d'une première résine sur la face avant de la structure obtenue à l'issue des étapes des figures 1 à 5.

On vient recouvrir intégralement (pleine plaque) la face avant de la structure, et en particulier combler les tranchées 21 et recouvrir l'empilement 13 et les portions 19' des métallisations 19 par la couche 23. La première résine est, par exemple, une résine époxy.

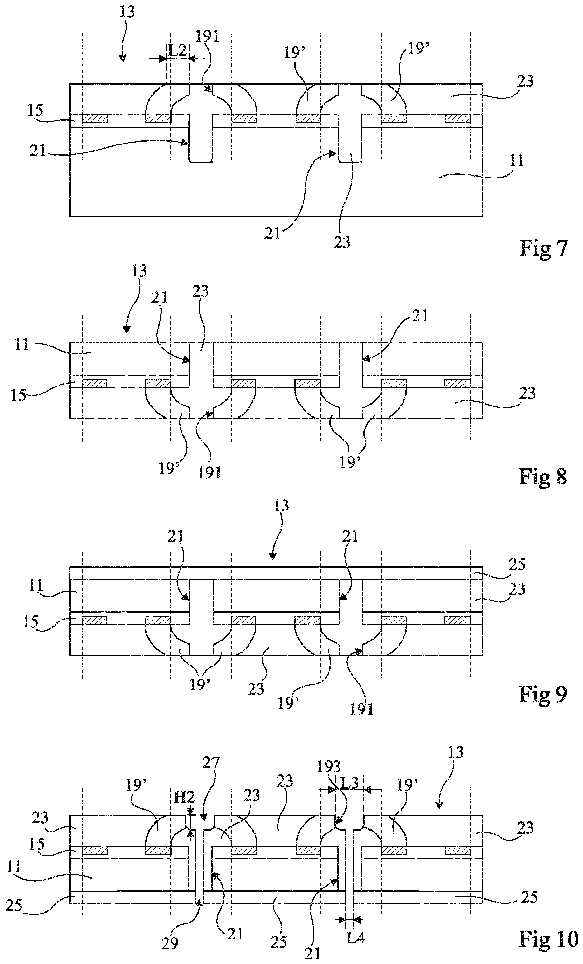

La figure 7 illustre, par une vue en coupe, une autre étape du procédé de fabrication de puces électroniques selon le premier mode de réalisation.

Plus particulièrement, la figure 7 illustre par une vue, partielle et schématique, une étape de planarisation de la face avant de la structure obtenue à l'issue des étapes des figures 1 à 6, par exemple par polissage mécano-chimique (CMP, Chemical Mechanical Polishing). Lors de cette étape, une partie supérieure de la couche 23 est retirée, de façon à découvrir les portions 19' des métallisations 19. Plus particulièrement, la planarisation est effectuée jusqu'à découvrir les portions 19' sur une longueur L2 (dans le plan de la puce) supérieure à 20 µm et sur une largeur supérieure à 100 µm.

La longueur L2 est, par exemple, comprise entre environ 20 µm et environ 600 µm, de préférence comprise entre environ 100 µm et environ 500 µm. La largeur des portions 19' est, par exemple, comprise entre environ 100 µm et environ 600 µm, de préférence comprise entre environ 100 µm et environ 400 µm. Ces dimensions sont choisies en fonction de la largeur des tranchées 21 et des dimensions des plots de contact 17.

La figure 8 illustre, par une vue en coupe, une autre étape du procédé de fabrication de puces électroniques selon le premier mode de réalisation.

Plus particulièrement, la figure 8 illustre par une vue, partielle et schématique, une étape d'amincissement de la structure, obtenue à l'issue des étapes des figures 1 à 7, par sa face arrière.

On notera que dans l'exemple de la figure 8, l'orientation de la structure est inversée par rapport aux vues en coupe des figures précédentes.

Le substrat 11 est aminci par sa face arrière (face supérieure en figure 8), par exemple par polissage mécano-chimique (CMP). Dans cet exemple, le substrat 11 est aminci par sa face arrière jusqu'à atteindre au moins le fond des tranchées 21, de sorte que, après amincissement, la première résine présente dans les tranchées 21 affleure au niveau de la face arrière du substrat 11. A l'issue de cette étape, les circuits intégrés 13 ne sont plus reliés entre eux que par ce qui subsiste de la couche 23 et le film support (non représenté en figure 8).

La figure 9 illustre, par une vue en coupe, une autre étape du procédé de fabrication de puces électroniques selon le premier mode de réalisation.

Plus particulièrement, la figure 9 est une vue, partielle et schématique, dans la même orientation que la figure 8, illustrant une étape de dépôt d'une deuxième couche 25 d'une deuxième résine, en face arrière de la structure obtenue à l'issue des étapes des figures 1 à 8.

La couche 25 de deuxième résine s'étend par exemple pleine plaque, de façon continue, et sur une épaisseur sensiblement constante sur toute la surface de la face arrière de la structure. La couche 25 de deuxième résine a, par exemple, une épaisseur comprise entre environ 10 µm et une épaisseur selon la dimension finale du boitier. L'épaisseur de la couche 25 est, de préférence, comprise entre environ 10 µm et environ 100 µm, par exemple de l'ordre de 25 µm. La deuxième résine peut être en époxy. Les première et deuxième résines peuvent être de même composition ou de compositions différentes.

La figure 10 illustre, par une vue en coupe, une autre étape du procédé de fabrication de puces électroniques selon le premier mode de réalisation.

Plus particulièrement, la figure 10 illustre par une vue, partielle et schématique, une étape de formation, du coté de la face avant de la structure obtenue à l'issue des étapes des figures 1 à 9, d'ouvertures 27 et une étape de découpe de la structure en puces individuelles comprenant chacune un unique circuit intégré 13. Préalablement à cette étape, la structure est rapportée, par sa face arrière, sur un film support, non représenté en figure 10.

Chaque ouverture 27 est réalisée, en vis-à-vis d'une première tranchée 21, localement entre deux portions 19' issues d'une même métallisation 19 (figure 2). Des ouvertures 27 peuvent, en variante, être réalisées en vis-à-vis de toutes les tranchées 21 et sur toute leur longueur.

Pour réaliser les ouvertures 27, on réalise un retrait partiel de la première résine (couche 23) située au dessus des premières tranchées 21. Le retrait partiel de la première résine est éventuellement accompagné d'un retrait d'une partie des portions 19' situées, en vue de dessus, de part et d'autre des tranchées 21, réduisant ainsi la longueur L2 (figure 7) des portions 19'. Les ouvertures 27 peuvent être, par exemple, des tranchées parallèles à la tranchée 21 sous-jacente. Les ouvertures 27 s'étendant par exemple sur toute la longueur de la tranchée 21 sous-jacente.

La formation des ouvertures engendre l'apparition de flancs 193 qui correspondent aux flancs métalliques mouillables des puces fabriquées selon ce mode de réalisation.

Les ouvertures 27 s'étendent verticalement, depuis la face avant de la structure, sur une profondeur H2 et une largeur L3. La profondeur H2 est déterminée de façon à optimiser le brasage des puces sur le dispositif extérieur et le contrôle visuel de la brasure. A titre d'exemple, la profondeur H2 est ainsi inférieure ou égale à la hauteur résiduelle (distance entre la face supérieure de l'empilement 15 et la face supérieure de la couche 23 de la première résine) des portions 19' de métallisations 19. La profondeur H2 est préférentiellement supérieure à la hauteur résiduelle des flancs 191 (figure 9) des portions 19'. La profondeur H2 est, par exemple comprise entre environ 20 µm et environ 400 µm, de préférence de l'ordre de 100 µm.

Les flancs 193 correspondent soit aux flancs 191 réduits en hauteur par l'étape de la figure 7, soit à des flancs en retrait si la largeur L3 est supérieure à l'intervalle entre les deux flancs 191 des étapes précédentes.

La largeur L3 est choisie, comme pour la profondeur H2, de façon à optimiser le brasage des puces sur le dispositif extérieur et le contrôle visuel de la brasure. Plus particulièrement, dans cet exemple, la largeur L3 des ouvertures 27 est choisie, d'une part, suffisamment grande pour permettre de dégager de la première résine les flancs 193 des portions 19' de chaque circuit intégré 13. D'autre part, la largeur L3 doit être suffisamment faible pour qu'un contrôle optique du métal de brasage ultérieur, remontant sur les flancs 193 de chaque portion 19' de métallisations soit réalisable. En effet, si la largeur L3 est trop grande, la couche 23 de la première résine peut gêner le contrôle. La largeur L3 doit en outre être suffisamment faible pour seulement dégager le flanc 193 de la portion 19' ou entamer la portion 19' de métallisation sans la retirer sur toute sa longueur.

Ainsi, les ouvertures 27 ont une largeur L3, par exemple comprise entre environ 10 µm et environ 150 µm, de préférence comprise entre environ 40 µm et environ 60 µm, la largeur L3 étant préférentiellement égale à environ 50 µm, par exemple égale à 50 µm.

Les ouvertures 27 peuvent, par exemple, être réalisées par sciage, en utilisant une lame de découpe de largeur supérieure à celle utilisée pour la réalisation des premières tranchées 21. Les ouvertures 27 peuvent, en variante, être réalisées par ablation laser.

Après formation des ouvertures 27, un flanc 193 de chaque portion 19' est exposé.

Afin de découper la structure en puces individuelles comprenant chacune un unique circuit intégré 13, des traits de coupe 29 sont réalisés dans les première (couche 23) et deuxième (couche 25) résines, en vis-à-vis des premières tranchées 21 et des ouvertures 27. Plus particulièrement, dans cet exemple, on vient former en vis-à-vis de chaque première tranchée 21, un trait de coupe 29 parallèle à ladite première tranchée 21. Dans cet exemple, les coupes 29 s'étendant sur toute la longueur de la première tranchée 21. Les traits de coupe 29 s'étendent, verticalement, de la face supérieure de la structure à la face inférieure de la couche 23 et débouchent sur la face arrière. La largeur L4 des traits de coupe 29 est inférieure à celle des tranchées 21 de sorte que chaque puce reste recouverte par la première résine (couche 23) sur ses quatre faces latérales. La largeur L4 des traits de coupe 29 est par exemple comprise entre environ 10 µm et environ 50 µm, de préférence comprise entre environ 20 µm et environ 30 µm, la largeur L4 étant préférentiellement égale à environ 25 µm, par exemple égale à 25 µm.

Les découpes 29 peuvent, par exemple, être réalisées par sciage, en utilisant une lame de découpe de largeur inférieure à celle utilisée pour la réalisation des tranchées 21. Les découpes 29 peuvent en variante être réalisées par ablation laser.

A l'issue de cette étape, la structure obtenue correspond à une pluralité de puces électronique, reliées uniquement par le film support (non représenté en figure 10).

Les puces peuvent ensuite être prélevées sur ce film support, en vue de leur montage dans un dispositif extérieur.

A titre de variante, la fabrication des ouvertures 27 peut être réalisée dès la fin de l'étape illustrée en figure 6.

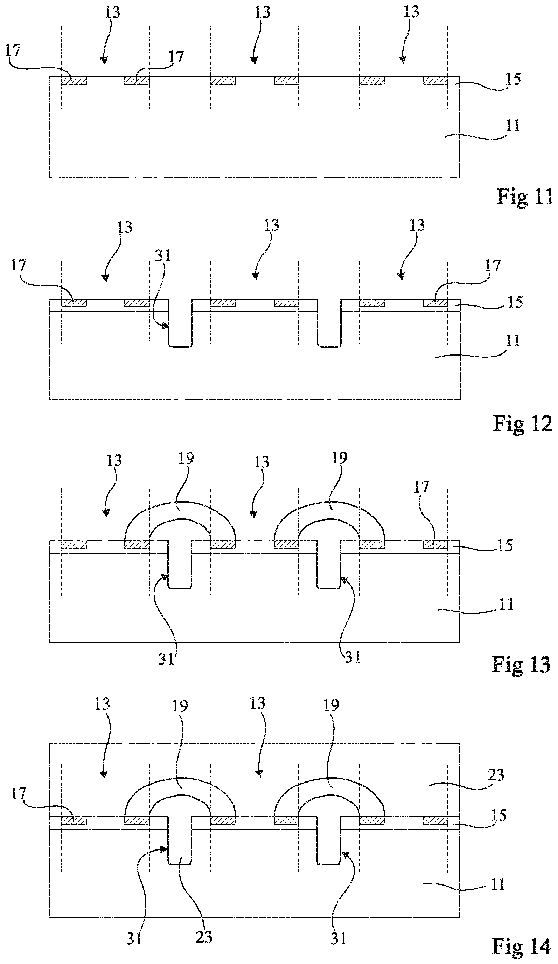

Les figures 11 à 18 illustrent, de façon schématique et partielle, des étapes successives d'un exemple du procédé de fabrication de puces électroniques selon un deuxième mode de réalisation.

Le deuxième mode de réalisation diffère du premier mode de réalisation essentiellement par le fait que des tranchées 31 (voir figure 12 et suivantes) ou sillons, sensiblement identiques aux premières tranchées 21 du premier mode de réalisation, sont réalisées avant la formation des métallisations 19.

La figure 11 illustre, par une vue en coupe, une étape du procédé de fabrication de puces électroniques selon un deuxième mode de réalisation.

Plus particulièrement, la figure 11 illustre par une vue, partielle et schématique, une structure de départ identique à la structure de départ, du procédé selon le premier mode de réalisation, représentée en figure 1.

La figure 12 illustre, par une vue en coupe, une autre étape du procédé de fabrication de puces électroniques selon le deuxième mode de réalisation.

Plus particulièrement, la figure 12 illustre par une vue, partielle et schématique, une étape de formation de sillons non traversants 31, ou deuxièmes tranchées, en face avant de la structure obtenue à l'issue de l'étape de la figure 11.

Les sillons 31, formés dans le deuxième mode de réalisation à l'étape illustrée en figure 12, sont sensiblement identiques aux premières tranchées 21 formées dans le premier mode de réalisation à l'étape illustrée en figure 4, à la différence près que les sillons 31 sont formés avant la réalisation des métallisations 19.

La figure 13 illustre, par une vue en coupe, une autre étape du procédé de fabrication de puces électroniques selon le deuxième mode de réalisation.

Plus particulièrement, la figure 13 illustre par une vue, partielle et schématique, une étape de formation, du coté de la face avant de la structure obtenue à l'issue des étapes des figures 11 et 12, des métallisations 19 sur et en contact avec les plots métalliques 17 de deux circuits 13 adjacents.

Les métallisations 19, formées dans le deuxième mode de réalisation à l'étape illustrée en figure 13, sont sensiblement identiques aux métallisations 19 formées dans le premier mode de réalisation à l'étape illustrée en figure 2, à la différence près que, dans le deuxième mode de réalisation, les métallisations 19 sont réalisées après des sillons 31.

La figure 14 illustre, par une vue en coupe, une autre étape du procédé de fabrication de puces électroniques selon le deuxième mode de réalisation.

Plus particulièrement, la figure 14 illustre par une vue, partielle et schématique, une étape de dépôt d'une première couche 23 d'une première résine sur la face avant de la structure obtenue à l'issue des étapes des figures 11 à 13.

Cette étape est sensiblement identique à l'étape illustrée en figure 6 du procédé selon le premier mode de réalisation à la différence près que, dans l'étape illustrée en figure 14, la couche 23 de la première résine recouvre entre autres les métallisations 19 et pas les portions 19' comme dans l'étape illustrée en figure 6.

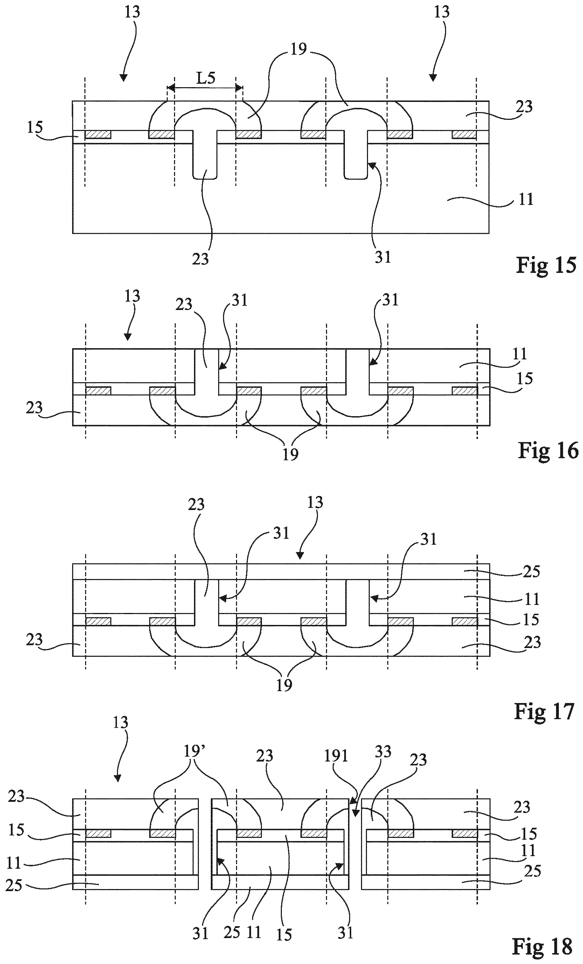

La figure 15 illustre, par une vue en coupe, une autre étape du procédé de fabrication de puces électroniques selon le deuxième mode de réalisation.

Plus particulièrement, la figure 15 illustre par une vue, partielle et schématique, une étape de planarisation de la face avant de la structure obtenue à l'issue des étapes des figures 11 à 14, par exemple par polissage mécano-chimique (CMP, Chemical Mechanical Polishing).

Lors de cette étape, une partie supérieure de la couche 23 de la première résine est retirée, de façon à découvrir les métallisations 19. Plus particulièrement, la planarisation est effectuée pour découvrir les métallisations 19 sur une largeur supérieure à 50 µm et sur une longueur L5 (dans le plan de la puce) choisie en fonction de la longueur devant subsister sur les puces finales, pour permettre de braser la puce sur le dispositif extérieur. A la fin de cette étape, chaque métallisation 19 est découverte sur une longueur L5 supérieure à 50 µm, par exemple, comprise entre environ 50 µm et environ 1 270 µm, de préférence comprise entre environ 300 µm et environ 1 040 µm. La largeur des métallisations 19 est supérieure à 100 µm, par exemple, comprise entre environ 100 µm et environ 600 µm, de préférence comprise entre environ 100 µm et environ 400 µm.

Ces dimensions sont choisies en fonction de la largeur des sillons 31 et les dimensions des plots de contact 17.

La figure 16 illustre, par une vue en coupe, une autre étape du procédé de fabrication de puces électroniques selon le deuxième mode de réalisation.

La figure 17 illustre, par une vue en coupe, une autre étape du procédé de fabrication de puces électroniques selon le deuxième mode de réalisation.

Plus particulièrement, les figures 16 et 17 illustrent par des vues, partielles et schématiques, une étape d'amincissement de la structure, obtenue à l'issue des étapes des figures 11 à 15, par sa face arrière et une étape de dépôt d'une deuxième couche 25 d'une deuxième résine, en face arrière de la structure.

On notera que, dans l'exemple des figures 16 et 17, l'orientation des structures est inversée par rapport aux vues en coupe des figures précédentes.

Ces deux étapes sont sensiblement identiques aux étapes illustrées respectivement en figures 8 et 9 du procédé selon le premier mode de réalisation.

La figure 18 illustre, par une vue en coupe, une autre étape du procédé de fabrication de puces électroniques selon le deuxième mode de réalisation.

Plus particulièrement, la figure 18 illustre par une vue, partielle et schématique, une étape de découpe de la structure en puces individuelles comprenant chacune un unique circuit intégré 13.

Préalablement à cette étape, la structure est fixée, par sa face arrière, sur un film support, non représenté en figure 18.

Afin de découper la structure en puces individuelles comprenant chacune un unique circuit intégré 13 et séparer chaque métallisation 19 en deux portions 19' de métallisation 19, des premières tranchées 33 sont réalisées dans les première et deuxième résines, en vis-à-vis des sillons 31.

Dans cette étape, les premières tranchées 33 sont sensiblement identiques aux traits de coupe 29 réalisés dans l'étape de la figure 10, à la différence près que la formation des premières tranchées 33 suffit (sans former d'ouvertures 27) à découvrir sur un moins un flanc 191 de chaque puce, une surface métallique issue des métallisations 19.

A l'issue de cette étape, la structure obtenue correspond à une pluralité de puces électronique, reliées uniquement par le film support (non représenté en figure 18). Les puces peuvent ensuite être prélevées sur ce film support en vue de leur montage dans ou sur un dispositif extérieur.

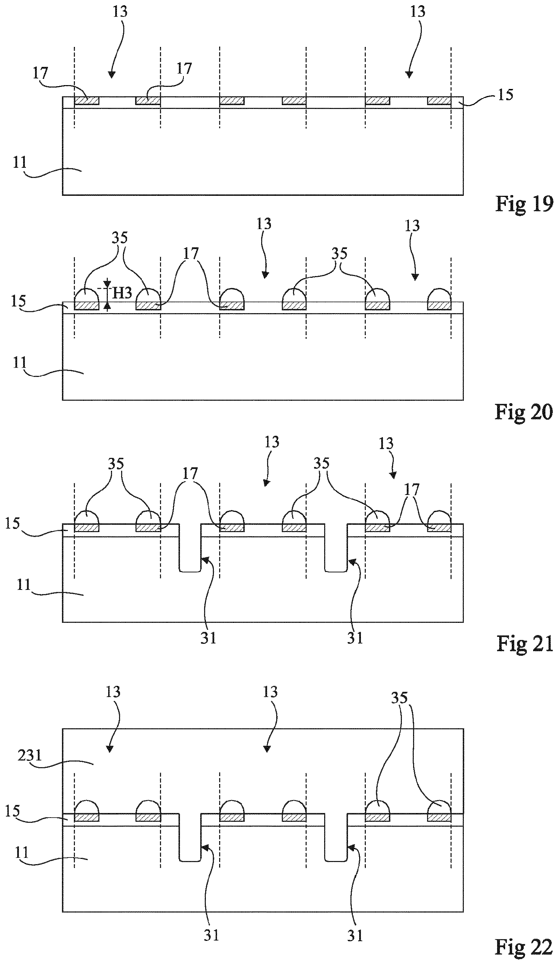

Les figures 19 à 28 illustrent, de façon schématique et partielle, des étapes successives d'un exemple du procédé de fabrication de puces électroniques selon le troisième mode de réalisation.

Le troisième mode de réalisation diffère du deuxième mode de réalisation essentiellement par le mode de mise en oeuvre des métallisations 19.

La figure 19 illustre, par une vue en coupe, une étape du procédé de fabrication de puces électroniques selon un troisième mode de réalisation.

Plus particulièrement, la figure 19 illustre par une vue, partielle et schématique, une structure de départ identique à la structure de départ, du procédé selon le deuxième mode de réalisation, représentée en figure 11.

La figure 20 illustre, par une vue en coupe, une autre étape du procédé de fabrication de puces électroniques selon le troisième mode de réalisation.

Plus particulièrement, la figure 20 illustre par une vue, partielle et schématique, une étape de formation de bossages (bumps) conducteurs 35 sur et en contact avec les plots métalliques 17.

Dans cet exemple, on vient former un bossage 35 sur chaque plot 17. Chaque bossage 35 s'étend par exemple, en vue de dessus sur toute la surface du plot 17 sous-jacent. La hauteur H3 des bossages 35 est, par exemple, comprise entre environ 1 µm et environ 300 µm. Les bossages 35 peuvent, par exemple, être formés par croissance électrolytique. Les bossages 35 peuvent être en un alliage à base d'étain, par exemple un alliage à base d'étain et d'argent (SnAg).

La figure 21 illustre, par une vue en coupe, une autre étape du procédé de fabrication de puces électroniques selon le troisième mode de réalisation.

Plus particulièrement, la figure 21 illustre par une vue, partielle et schématique, une étape de formation de sillons non traversants 31, ou deuxièmes tranchées, en face supérieure de la structure obtenue à l'issue des étapes des figures 19 et 20.

Les sillons 31, formés dans le troisième mode de réalisation à l'étape illustrée en figure 21, sont sensiblement identiques aux sillons 31 formés dans le deuxième mode de réalisation à l'étape illustrée en figure 12.

La figure 22 illustre, par une vue en coupe, une autre étape du procédé de fabrication de puces électroniques selon le troisième mode de réalisation.

Plus particulièrement, la figure 22 illustre par une vue, partielle et schématique, une étape de dépôt d'une première couche 231 d'une première résine sur la face avant de la structure obtenue à l'issue des étapes des figures 19 à 21.

Plus particulièrement, on vient recouvrir intégralement (pleine plaque) la face avant de la structure et, en particulier, combler les sillons 31 et recouvrir l'empilement 13 et les bossages 35 par la première couche 231 de la première résine. La première résine est, par exemple, une résine époxy.

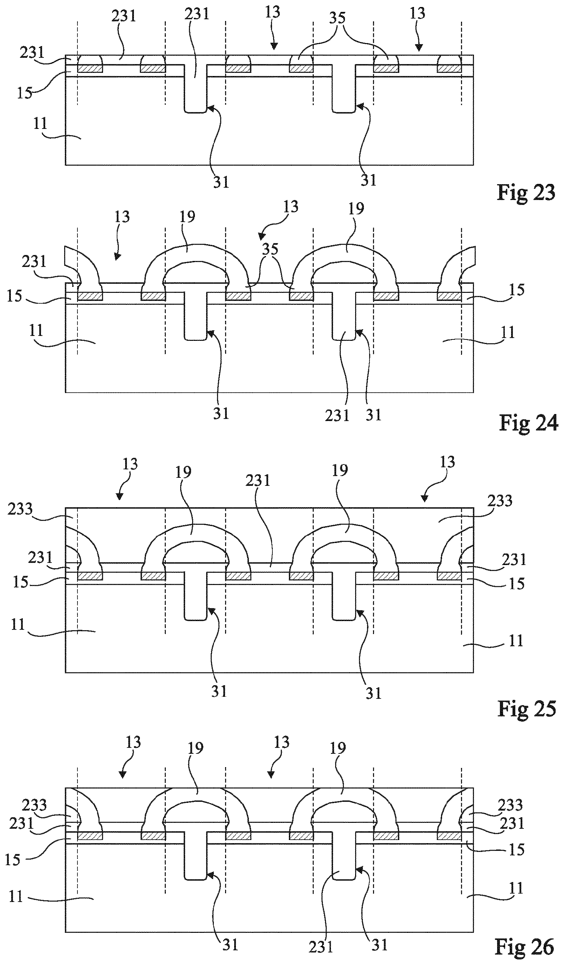

La figure 23 illustre, par une vue en coupe, une autre étape du procédé de fabrication de puces électroniques selon le troisième mode de réalisation.

Plus particulièrement, la figure 23 illustre par une vue, partielle et schématique, une étape de planarisation de la face avant de la structure obtenue à l'issue des étapes des figures 19 à 22, par exemple par polissage mécano-chimique (CMP, Chemical Mechanical Polishing). Lors de cette étape, une partie supérieure de la première résine est retirée, de façon à découvrir les bossages 35. Plus particulièrement, la planarisation est effectuée jusqu'à découvrir, par exemple, les bossages 35 sur une surface supérieure à 10 µm x 10 µm.

La figure 24 illustre, par une vue en coupe, une autre étape du procédé de fabrication de puces électroniques selon le troisième mode de réalisation.

Plus particulièrement, la figure 24 illustre par une vue, partielle et schématique, une étape de formation, du coté de la face avant de la structure obtenue à l'issue des étapes des figures 19 à 23, des métallisations 19 sur et en contact avec les bossages 35 de deux plots 17 de deux circuits 13 adjacents.

Dans le mode de réalisation représenté en figure 24, les métallisations 19 sont sensiblement identiques aux métallisations 19 fabriquées dans le deuxième mode de réalisation à l'étape illustrée en figure 2 à la différence près que les métallisations 19 en figure 24 sont réalisées sur et en contact avec les bossages 35.

La figure 25 illustre, par une vue en coupe, une autre étape du procédé de fabrication de puces électroniques selon le troisième mode de réalisation.

Plus particulièrement, la figure 25 illustre par une vue, partielle et schématique, une étape de dépôt d'une deuxième couche 233 de la première résine sur la face avant de la structure obtenue à l'issue des étapes des figures 19 à 24.

On vient recouvrir intégralement (pleine plaque) la face avant de la structure, et en particulier recouvrir la première couche 231 et les métallisations 19 par la deuxième couche 233 de la première résine.

La figure 26 illustre, par une vue en coupe, une autre étape du procédé de fabrication de puces électroniques selon le troisième mode de réalisation.

Plus particulièrement, la figure 26 illustre par une vue, partielle et schématique, une étape de planarisation de la face avant de la structure obtenue à l'issue des étapes des figures 19 à 25 par exemple par polissage mécano-chimique (CMP, Chemical Mechanical Polishing). Lors de cette étape, une partie supérieure de la couche 233 de la première résine est retirée, de façon à découvrir les métallisations 19.

Cette étape est sensiblement identique à l'étape de planarisation du deuxième mode de réalisation illustrée en figure 15.

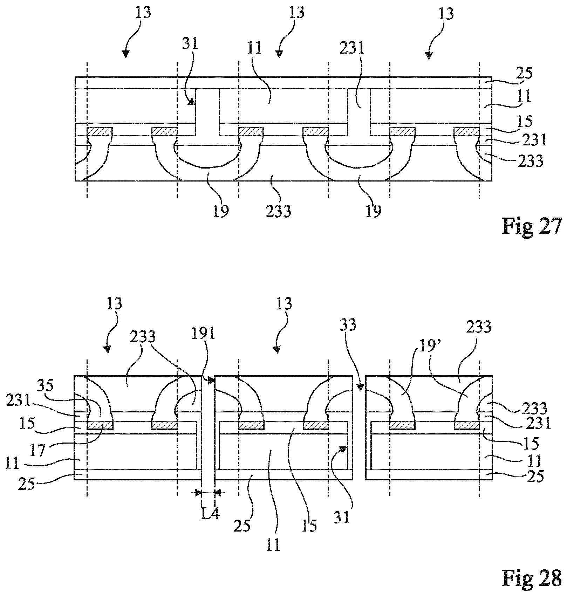

La figure 27 illustre, par une vue en coupe, une autre étape du procédé de fabrication de puces électroniques selon le troisième mode de réalisation.

Plus particulièrement, la figure 27 illustre par une vue, partielle et schématique, une étape d'amincissement de la structure, obtenue à l'issue des étapes des figures 19 à 26, par sa face arrière et une étape de dépôt d'une troisième couche 25 d'une deuxième résine, en face arrière de la structure.

On notera que dans l'exemple de la figure 27, l'orientation des structures est inversée par rapport aux vues en coupe des figures précédentes.

Cette étape est sensiblement identique aux étapes illustrées en figures 16 et 17 du procédé selon le deuxième mode de réalisation.

La figure 28 illustre, par une vue en coupe, une autre étape du procédé de fabrication de puces électroniques selon le troisième mode de réalisation.

Plus particulièrement, la figure 28 illustre par une vue, partielle et schématique, une étape de découpe de la structure en puces individuelles comprenant chacune un unique circuit intégré 13.

Cette étape est sensiblement identique à l'étape illustrée en figures 18 du procédé selon le deuxième mode de réalisation.

Un avantage des deuxième et troisième modes de réalisations est qu'ils permettent de former des puces électroniques possédant des flancs mouillables sans marches.

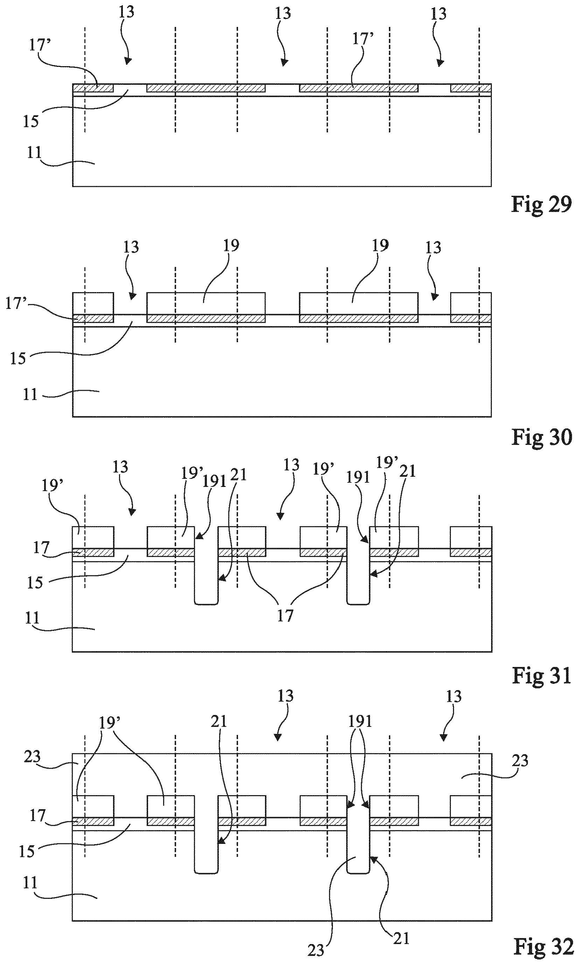

Les figures 29 à 36 illustrent, de façon schématique et partielle, des étapes successives d'un exemple d'un procédé de fabrication de puces électroniques selon un quatrième mode de réalisation.

Le quatrième mode de réalisation diffère du deuxième mode de réalisation essentiellement par la forme et la disposition des métallisations 19.

La figure 29 illustre, par une vue en coupe, une étape du procédé de fabrication de puces électroniques selon un quatrième mode de réalisation.

Plus particulièrement, la figure 29 illustre par une vue, partielle et schématique, une structure de départ identique à la structure de départ du procédé selon le deuxième mode de réalisation, représentée en figure 11, à la différence près que les circuits sont reliés entre eux par une même zone 17' conductrice destinée à définir les plots 17 et reliant deux circuits 13 adjacents.

La figure 30 illustre, par une vue en coupe, une autre étape du procédé de fabrication de puces électroniques selon le quatrième mode de réalisation.

Plus particulièrement, la figure 30 illustre par une vue, partielle et schématique, une étape de formation de métallisations 19 sur et en contact avec la zone 17'.

Les métallisations 19 sont fabriquées par un dépôt métallique, sur et au contact des zones 17', au travers d'un masque. Le métal déposé est, dirigé par une ouverture du masque en vis-à-vis des zones 17'. La hauteur des métallisations 19 est, par exemple, comprise entre environ 1 µm et environ 100 µm.

Les métallisations 19 peuvent être en un alliage à base d'étain, par exemple un alliage à base d'étain et d'argent (SnAg). En variante, les métallisations 19 peuvent être en un alliage à base de cuivre.

La figure 31 illustre, par une vue en coupe, une autre étape du procédé de fabrication de puces électroniques selon le quatrième mode de réalisation.

Plus particulièrement, la figure 31 illustre par une vue, partielle et schématique, une étape de formation de premières tranchées 21 en face supérieure de la structure obtenue à l'issue des étapes des figures 29 à 30.

Les premières tranchées 21, formées dans le quatrième mode de réalisation à l'étape illustrée en figure 31, sont sensiblement identiques aux premières tranchées 21 formées dans le premier mode de réalisation à l'étape illustrée en figure 4 à la différence près que les métallisations 19 ont, par exemple, une forme parallélépipédique, et non une forme de partie d'anneau ou de pont.

A la fin de cette étape la structure comprend des portions 19' de métallisations 19.

La figure 32 illustre, par une vue en coupe, une autre étape du procédé de fabrication de puces électroniques selon le quatrième mode de réalisation.

Plus particulièrement, la figure 32 illustre par une vue, partielle et schématique, une étape de dépôt d'une couche 23 d'une première résine sur la face avant de la structure obtenue à l'issue des étapes des figures 29 à 31.

Cette étape est sensiblement identique à l'étape illustrée en figure 6 du procédé selon le premier mode de réalisation.

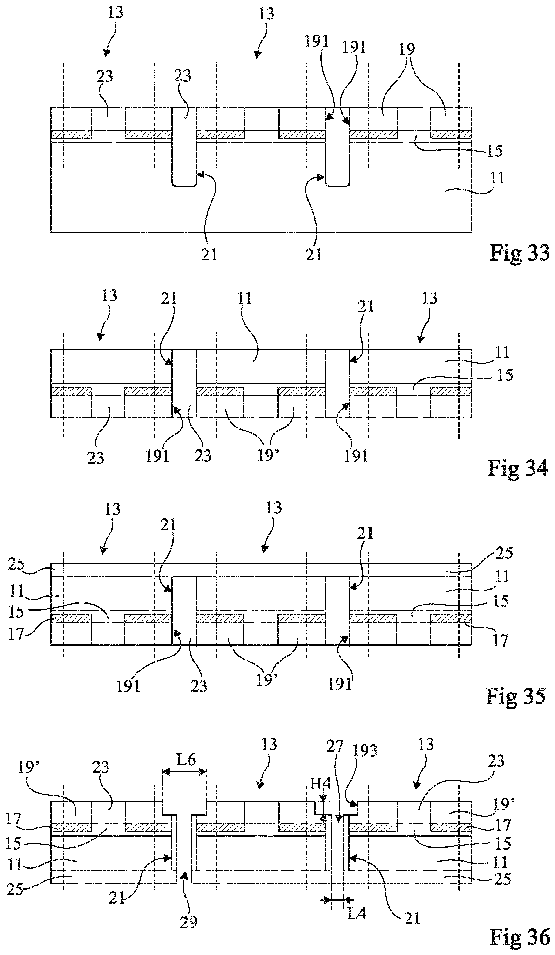

La figure 33 illustre, par une vue en coupe, une autre étape du procédé de fabrication de puces électroniques selon le quatrième mode de réalisation.

Plus particulièrement, la figure 33 illustre par une vue, partielle et schématique, une étape de planarisation de la face avant de la structure obtenue à l'issue des étapes des figures 29 à 32, par exemple par polissage mécano-chimique (CMP, Chemical Mechanical Polishing).

Lors de cette étape, une partie supérieure de la couche 23 est retirée, de façon à au moins découvrir les portions 19' des métallisations 19.

La figure 34 illustre, par une vue en coupe, une autre étape du procédé de fabrication de puces électroniques selon le quatrième mode de réalisation.

Plus particulièrement, la figure 34 illustre par une vue, partielle et schématique, une étape d'amincissement de la structure, obtenue à l'issue des étapes des figures 29 à 33, par sa face arrière.

On notera que dans l'exemple de la figure 34, l'orientation de la structure est inversée par rapport aux vues en coupe des figures précédentes.

Cette étape est sensiblement identique à l'étape illustrée en figure 8 du procédé selon le premier mode de réalisation.

La figure 35 illustre, par une vue en coupe, une autre étape du procédé de fabrication de puces électroniques selon le quatrième mode de réalisation.

Plus particulièrement, la figure 35 est une vue, partielle et schématique, dans la même orientation que la figure 34, illustrant une étape de dépôt d'une couche 25 d'une deuxième résine, en face arrière de la structure obtenue à l'issue des étapes des figures 29 à 34.

Cette étape est sensiblement identique à l'étape illustrée en figure 9 du procédé selon le premier mode de réalisation.

La figure 36 illustre, par une vue en coupe, une autre étape du procédé de fabrication de puces électroniques selon le quatrième mode de réalisation.

Plus particulièrement, la figure 36 illustre par une vue, partielle et schématique, une étape de formation, du coté de la face avant de la structure obtenue à l'issue des étapes des figures 29 à 35, d'ouvertures 27 et une étape de découpe de la structure en puces individuelles comprenant chacune un unique circuit intégré 13. Préalablement à cette étape, la structure est rapportée, par sa face arrière, sur un film support, non représenté en figure 36.

Les ouvertures 27, formées dans le quatrième mode de réalisation à l'étape illustrée en figure 36, sont sensiblement identiques aux ouvertures 27 formées dans le premier mode de réalisation à l'étape illustrée en figure 10 à la différence près de la forme des portions 19' de métallisations 19. Les dimensions des ouvertures 27 formées dans le quatrième mode de réalisation sont choisies de la même façon que les dimensions des ouvertures 27 formées dans le premier mode de réalisation. Toutefois, compte tenu de la différence de forme des ouvertures 27 entre ces deux modes de réalisations, leurs dimensions ne sont pas numériquement identiques.

Les ouvertures 27 s'étendent verticalement, depuis la face avant de la structure, sur une profondeur H4 et une largeur L6. A titre d'exemple, la profondeur H4 est inférieure ou égale à la hauteur résiduelle des portions 19' de métallisations 19. La profondeur H4 est, par exemple de l'ordre de 100 µm.

Les ouvertures 27 ont une largeur L6, par exemple comprise entre environ 15 µm et environ 80 µm, de préférence comprise entre environ 40 µm et environ 50 µm, la largeur L6 étant préférentiellement égale à environ 45 µm, par exemple égale à 45 µm.

Afin de découper la structure en puces individuelles comprenant chacune un unique circuit intégré 13, des traits de coupe 29 sont réalisés dans les première et deuxième résines, en vis-à-vis des premières tranchées 21 et des ouvertures 27.

Les traits de coupe 29 représentés en figure 36 sont sensiblement identiques aux traits de coupe 29 de l'étape du premier mode de réalisation illustrée en figure 10.

A l'issue de cette étape, la structure obtenue correspond à une pluralité de puces électronique, reliées uniquement par le film support (non représenté en figure 36). Les flancs des portions 19' exposés à l'étape de formation des ouvertures 27 correspondent à des flancs mouillables des puces.

Les puces peuvent ensuite être prélevées sur le film support, non représentée en figure 10, en vue de leur montage dans un dispositif extérieur.

A titre de variante, la fabrication des ouvertures 27 peut être réalisée dès la fin de l'étape illustrée en figure 32.

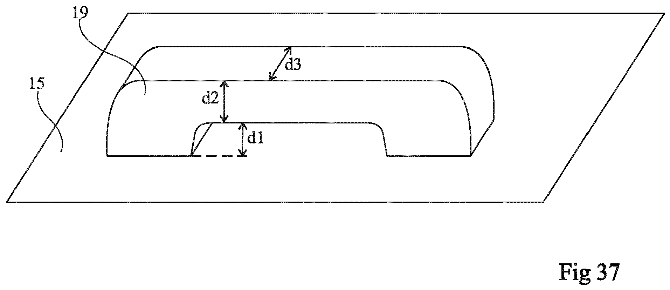

La figure 37 représente, par une vue en perspective, une variante de réalisation.

Plus particulièrement, la figure 37 représente une variante de réalisation d'une métallisation 19.

La métallisation 19, illustrée en figure 37, a la forme d'un pont non arrondi, dont la face supérieure est quasi-plane.

La métallisation 19 est caractérisée par sa hauteur d1 qui sépare la couche 15 de la face inférieure de sa partie centrale. La hauteur d1 est, par exemple, comprise entre environ 5 µm et environ 70 µm, de préférence comprise entre environ 15 µm et environ 50 µm.

La métallisation 19 est caractérisée de plus par son épaisseur d2 au niveau de sa partie centrale (horizontale). L'épaisseur d2 est, par exemple, comprise entre environ 20 µm et environ 400 µm, de préférence comprise entre environ 50 µm et environ 250 µm.

La métallisation 19 est en outre caractérisée sa largeur d3, la largeur d3 est, par exemple, comprise entre environ 20 µm et environ 600 µm, de préférence comprise entre environ 50 µm et environ 400 µm.

Divers modes de réalisation et variantes ont été décrits. L'homme de l'art comprendra que certaines caractéristiques de ces divers modes de réalisation et variantes pourraient être combinées, et d'autres variantes apparaitront à l'homme de l'art. En particulier, des premier et troisième modes de réalisation peuvent être combinés et les deuxième et quatrième modes de réalisations peuvent également être combinés. Les modes de réalisations décrits ne se limitent pas aux exemples de dimensions et de matériaux mentionnées ci-dessus.

Enfin, la mise en oeuvre pratique des modes de réalisation et variantes décrits est à la portée de l'homme du métier à partir des indications fonctionnelles données ci-dessus.

## Revendications

1. Procédé de fabrication de puces électroniques comprenant les étapes suivantes :
a. former, du coté d'une première face d'un substrat semiconducteur (11), dans et sur lequel a été formée une pluralité de circuits intégrés (13), des métallisations (19) reliant des contacts de circuits intégrés (13) voisins ; et
b. former, du coté de ladite première face du substrat (11), des premières tranchées (21 ; 33) séparant latéralement les circuits intégrés (13) et couper les métallisations (19) reliant des circuits intégrés (13) adjacents, pour former au moins une portion (19') de métallisations (19) au niveau de chacun des circuits (13) adjacents.

2. Procédé selon la revendication 1, dans lequel les métallisations (19) sont en contact, uniquement, avec des contacts métalliques (17) des circuits intégrés (13).

3. Procédé selon la revendication 1 ou 2, dans lequel l'étape a) est suivie de l'étape b).

4. Procédé selon la revendication 3, dans lequel les premières tranchées (21) s'étendent verticalement dans le substrat (11) sur une profondeur supérieure à celle des circuits intégrés (13) et inférieure à l'épaisseur du substrat (11).

5. Procédé selon la revendication 4, dans lequel l'étape b) est suivie d'une étape c) de dépôt d'une couche (23) d'une première résine sur l'ensemble de la première face, ladite première résine pénétrant dans les premières tranchées (21) et recouvrant lesdites portions (19') desdites métallisations (19).

6. Procédé selon la revendication 5, dans lequel l'étape c) est suivi d'une étape d) de planarisation de la première face jusqu'à découvrir lesdites portions (19') desdites métallisations (19).

7. Procédé selon la revendication 6, dans lequel l'étape d) est effectuée jusqu'à découvrir lesdites portions (19') desdites métallisations (19) sur une surface suffisante pour pouvoir souder la puce, par sa première face, sur un dispositif autre que la puce, la planarisation étant de préférence effectuée jusqu'à découvrir lesdites portions (19') desdites métallisations (19) sur une longueur supérieure à environ 20 µm.

8. Procédé selon la revendication 1, dans lequel l'étape a) est précédée d'une étape e) de formation de deuxièmes tranchées (31) du coté de la première face, séparant latéralement les circuits intégrés (13), les deuxièmes tranchées (31) s'étendant verticalement dans le substrat (11) sur une profondeur supérieure à celle des circuits intégrés (13) et inférieure à l'épaisseur du substrat (11).

9. Procédé selon la revendication 8, dans lequel l'étape a) est suivie d'une étape f) de dépôt d'une couche (23) d'une première résine sur l'ensemble de la première face, ladite première résine pénétrant dans les deuxièmes tranchées (31) et recouvrant lesdites métallisations (19).

10. Procédé selon la revendication 8, dans lequel :
l'étape e) est précédée d'une étape g) de formation de bossages (35) à l'aplomb des circuits intégrés (13) ; et
entre les étape e) et a), est réalisée une étape h) de dépôt d'une première couche (231) d'une première résine sur l'ensemble de la première face, ladite première résine pénétrant dans les deuxièmes tranchées (31) et recouvrant les bossages (35), et de planarisation de ladite première couche (231) au moins jusqu'à découvrir les bossages (35).

11. Procédé selon la revendication 10, dans lequel les métallisations (19) sont reliées aux circuits intégrés (13) par l'intermédiaire des bossages (35).

12. Procédé selon la revendication 10 ou 11, dans lequel l'étape a) est suivie par une étape i) de dépôt d'une deuxième couche (233) de la première résine sur la première couche (231) de la première résine.

13. Procédé selon la revendication 9 ou 12, dans lequel l'étape f) ou i) est suivie d'une étape j) de planarisation de la première face de façon à découvrir chaque métallisation (19), lesdites métallisations (19) étant découvertes sur une longueur, par exemple, supérieure à environ 200 µm.

14. Procédé selon l'une quelconque des revendications 6, 7 et 13, dans lequel l'étape d) ou j) est suivie d'une étape k) d'amincissement du substrat (11) par une deuxième face du substrat (11), située à l'opposé de la première face, au moins jusqu'à atteindre la première résine, et de dépôt d'une couche (25) d'une deuxième résine sur la deuxième face.

15. Procédé selon la revendication 14 dans son rattachement à la revendication 6 ou 7, dans lequel l'étape k) est suivie par une étape 1) comprenant les étapes de :
retrait partiel de la couche (23) de la première résine, sur une hauteur inférieure ou égale à la hauteur desdites portions (19') desdites métallisations (19), pour former des ouvertures (27) situées en vis-à-vis des premières tranchées (21) et s'étendant sur une largeur supérieure ou égale à celle des premières tranchées (21), de façon à dégager un flanc (191, 193) d'au moins une portion (19') de chaque circuit intégré (13) ; et
individualiser les puces par découpe selon un chemin de découpe dans les premières tranchées (21), sur une largeur inférieure à la largeur des premières tranchées (21) .

16. Procédé selon la revendication 14 dans son rattachement à la revendication 13, dans lequel l'étape k) est suivie de l'étape b).
